# EUROPÄISCHE PATENTSCHRIFT

(11) **EP 2 748 922 B1**
(45) Veröffentlichungstag und Bekanntmachung des Hinweises auf die Patenterteilung: **23.03.2016**
(21) Anmeldenummer: 12745812.3
(22) Anmeldetag: 30.07.2012
(51) Int. Cl.: H02N 2/18

(54) **ENERGIEÜBERTRAGUNGSEINHEIT**
ENERGY TRANSMITTING UNIT
MODULE DE TRANSFERT D'ÉNERGIE

(30) Priorität: 23.08.2011 DE 102011052923
(43) Veröffentlichungstag der Anmeldung: 02.07.2014
(73) Patentinhaber: GSI Helmholtzzentrum für Schwerionenforschung GmbH, 64291 Darmstadt (DE)
(72) Erfinder: KLEIPA, Volker, 63500 Seligenstadt (DE)
(86) Internationale Anmeldenummer: PCT/EP2012/064866
(87) Internationale Veröffentlichungsnummer: WO 2013/026652

(56) Entgegenhaltungen:
- EP-A2- 2 221 087
- WO-A2-2007/149516
- DE-A1- 19 910 619
- DE-A1-102007 059 179
- US-A1- 2006 049 717
- DAI X ET AL: "Modeling, characterization and fabrication of vibration energy harvester using Terfenol-D/PZT/Terfenol-D composite transducer", SENSORS AND ACTUATORS A, ELSEVIER SEQUOIA S.A., LAUSANNE, CH, Bd. 156, Nr. 2, 1. Dezember 2009 (2009-12-01), Seiten 350-358, XP026778962, ISSN: 0924-4247, DOI: 10.1016/J.SNA.2009.10.002 [gefunden am 2009-10-24]

## Beschreibung

Die Erfindung betrifft eine Energieübertragungsvorrichtung, die zumindest eine Energieeintragseinrichtung und zumindest eine als Piezoelementeinrichtung ausgebildete Energieerzeugungseinrichtung aufweist.

Zur Durchführung unterschiedlichster Messaufgaben und Regelungsaufgaben ist es erforderlich Energie, insbesondere elektrische Energie, an unterschiedlichsten Orten bereitzustellen. Hierzu werden in vielen Fällen elektrische Kabel verwendet, mit denen elektrische Energie beispielsweise aus dem öffentlichen Stromnetz zu den Orten geführt wird, an denen diese benötigt wird, also beispielsweise zu den mit elektrischer Energie zu versorgenden Messgeräten bzw. Regeleinrichtungen. Bei speziellen Einsatzorten bzw. Anwendungsgebieten kann jedoch eine Zuführung elektrischer Energie mithilfe von elektrischen Kabeln zu Problemen führen oder sogar unmöglich sein.

Derartige besondere Einsatzbedingungen können beispielsweise vorliegen, wenn eine galvanische Isolierung der mit elektrischer Energie zu versorgenden Komponenten erfolgen muss, insbesondere dann, wenn sehr hohe Potenzialdifferenzen vorliegen. Derartige Bedingungen bestehen beispielsweise bei Hochspannungsanlagen oder im Forschungsumfeld beispielsweise bei Van-de-Graaff-Beschleunigern.

Probleme können auch dann auftreten, wenn besonders problematische Umgebungsbedingungen vorliegen. Dies kann beispielsweise dann der Fall sein, wenn die elektrischen Kabel durch elektromagnetisch stark belastete Gebiete geführt werden müssen, so dass die elektrischen Kabel Störsignale aufnehmen können, die wiederum zu Problemen bei Regelungskomponenten bzw. zu einer Verschlechterung der Messgenauigkeit von Messgeräten führen können, wenn keine vergleichsweise aufwändigen Glättungs- bzw. Filterungsmaßnahmen ergriffen werden.

In Fällen, in denen die mit elektrischer Energie zu versorgenden Komponenten in sehr starken Magnetfeldern angeordnet sind, sind darüber hinaus klassische Transformatoren nicht sinnvoll verwendbar. Dies hängt damit zusammen, dass Transformatoren in aller Regel mit ferromagnetischen Kernen bzw. Jochen ausgebildet werden, um deren Wirkungsgrad zu erhöhen. Befindet sich ein derartiges ferromagnetisches Material jedoch in einem starken Magnetfeld, so kann sich dieses bereits aufgrund des externen Magnetfelds im Sättigungsbereich befinden. Dementsprechend ist das ferromagnetische Material zu Zwecken der Spannungstransformation "nicht verfügbar", so dass es zu entsprechenden Problemen kommt.

Für den Einsatz unter EMV-Bedingungen (EMV = elektromagnetische Verträglichkeit) und/oder bei sehr starken (statischen) Magnetfeldern (typischerweise Magnetfeldern mit Feldstärken ≥ 0,1 Tesla, 0,25 Tesla, 0,5 Tesla, 0,75 Tesla, 1,0 Tesla, 1,25 Tesla, 1,5 Tesla, 1,75 Tesla bzw. 2,0 Tesla) wurde bereits die Verwendung von so genannten Piezowandlern vorgeschlagen. Bei diesen wird ein Piezokristall mit elektrischer Energie (in aller Regel einem elektrischen Wechselstrom) versorgt, so dass dieser seine Größe ändert, insbesondere zu schwingen anfängt. Dieser Piezokristall ist mechanisch mit einem zweiten Piezokristall verbunden, so dass die mechanische Verformung (Schwingung) des ersten Piezokristalls auf den zweiten Piezokristall übertragen wird und hier zur Erzeugung einer entsprechenden elektrischen Spannung führt, die über elektrische Kontakte abgeführt werden kann. Derartige Piezowandler weisen in aller Regel eine sehr gute elektromagnetische Verträglichkeit auch unter schwierigen EMV-Bedingungen auf. Darüber hinaus sind Piezokristalle meist sehr unempfindlich gegenüber starken externen Magnetfeldern sowie gegenüber radioaktiver Strahlung (insbesondere Gamma-Strahlung). Obwohl Piezowandler viele Vorteile aufweisen, besteht ein großer Nachteil im Eigenfrequenzspektrum (insbesondere Resonanzfrequenzen) bzw. Schwingungsverhalten (in Abhängigkeit von der angelegten elektrischen Spannung) des Eingangs-Piezokristalls, der elektrische Energie in mechanische Schwingungen wandelt. Die dadurch entstehenden Übertragungscharakteristiken von Piezowandlern erweisen sich in der praktischen Anwendung oftmals als problematisch bis hin zur Unbrauchbarkeit derartiger Piezowandler bei bestimmten Einsatzgebieten.

In der wissenschaftlichen Veröffentlichung "Modeling, characterization and fabrication of vibration energy harvester using Terfenol-D/PZT/Terfenol-D composite transducer" von X. Dai et al. in Sensors and Actuators A, Band 156, Nr. 2, 1. Dezember 2009, Seiten 350-358 wird ein Energieernter ("energy harvester") vorgeschlagen, mit dem Vibrationsenergie in elektrische Energie umgewandelt werden kann. Der Energieernter verwendet vier Magnete, die am freien Ende eines Hebelarms angeordnet sind. Die Magnete erzeugten einen konzentrierten Flussgradienten im Luftspalt der Magnete wobei der magnetoelektrische Wandler in den Luftspalt zwischen den Magneten eingesetzt ist. Wird der Energieernter mechanisch angeregt, bewegt sich der Magnetkreis relativ zum magnetoelektrischen Wandler. Der magnetoelektrische Wandler wird dabei Magnetfeldänderungen unterworfen und gibt elektrische Leistung aus.

In der internationalen Patentanmeldung WO 2007/149516 A2 wird ein Energieernter vorgeschlagen, bei dem ein Verbundkörper aus magnetostriktivem Material und piezoelektrischem Material einem Magnetfeld ausgesetzt wird. Der Verbundkörper aus magnetostriktivem Material und piezoelektrischem Material kann in eine Batterie oder in eine elektrische Speichereinheit eingebaut werden.

In der europäischen Patentanmeldung EP 2 221 087 A2 wird ein aktives medizinisches Implantat mit einer Energieversorgung beschrieben, die einen mechanischen Schwinger oder Rotor aufweist, der durch Bewegungen des Implantat-Trägers und/oder äußere Anregung in Schwingung bzw. Drehung versetzt wird und energetisch derart mit einem elektrischen Verbraucher und/oder einem Energiespeicher verbunden ist, dass ein Teil der mit der Schwingung bzw. Drehung erzeugten kinetischen Energie in den Verbraucher und/oder Energiespeicher eingekoppelt wird.

In der deutschen Offenlegungsschrift DE 10 2007 059 179 A1 ist ein drehbarer, zylinderförmiger Körper offenbart, der sich relativ zu einem ortsfesten Gehäuse bewegt. Im Körper sind Permanentmagnete integriert, welche auf gegenüberliegend angeordnete Permanentmagnete eine Kraft ausüben. Letztere wirken auf einen Piezokristall, welcher unter der resultierenden Stauchung eine Spannung generiert und diese dann als nutzbare Energieform zur Verfügung stellt.

Es besteht daher nach wie vor ein Bedürfnis an Energieerzeugungsvorrichtungen, welche Vorteile gegenüber im Stand der Technik bekannter Energieerzeugungsvorrichtungen aufweisen.

### Die Erfindung löst diese Aufgabe.

Es wird vorgeschlagen, eine Energieübertragungsvorrichtung, welche zumindest eine Energieeintragseinrichtung und zumindest eine als Piezoelementeinrichtung ausgebildete Energieerzeugungseinrichtung aufweist, derart auszubilden, dass die zumindest eine Energieeintragseinrichtung zumindest teilweise als elektrische Magnetfelderzeugungseinrichtung ausgebildet ist und derart ausgebildet und eingerichtet ist, dass sie zumindest teilweise und/oder zumindest zeitweise unter Wirkvermittlung eines externen magnetischen Felds arbeitet, derart, dass sie eine Lorentzkraft auf die zumindest eine Energieerzeugungseinrichtung ausübt. Erfindungsgemäß ist die in die zumindest eine Energieeintragseinrichtung eingetragene Energie zumindest zeitweise und/oder zumindest teilweise im Wesentlichen von der gleichen Energieform wie die von der zumindest einen Energieerzeugungseinrichtung erzeugten und ausgegebenen Energie. Es handelt sich dabei im Wesentlichen um elektrische Energie.

Es wird also im Wesentlichen elektrische Energie in die Energieübertragungsvorrichtung eingespeist und von der Energieübertragungsvorrichtung im Wesentlichen elektrische Energie ausgegeben. Auch wenn die grundsätzliche Energieform sich dabei nicht ändert, so ist es dennoch möglich (und gegebenenfalls auch von Vorteil), dass bei der Energieübertragungsvorrichtung beispielsweise die elektrische Spannung, die elektrische Stromstärke und/oder die Frequenz und/oder die Amplitudenform und/oder das Pulsweitenverhältnis zumindest zeitweise und/oder zumindest teilweise geändert wird. Eine derartige Änderung kann dabei in beide Richtungen erfolgen, so dass beispielsweise die elektrische Spannung "herauf transformiert" bzw. "herunter transformiert" werden kann. Auch ist es gegebenenfalls möglich, dass sich die Richtung und/oder das Verhältnis der Wertänderung verändern, insbesondere in Abhängigkeit von einem Steuerimpuls (also zum Beispiel entsprechend einer Nutzervorgabe). Unter einer Piezoelementeinrichtung sind im vorliegenden Zusammenhang gegebenenfalls sämtliche Mittel zu verstehen, welche eine mechanische Formveränderung, eine mechanische Größenveränderung und/oder einen angelegten mechanischen Druck in ein elektrisches Signal umwandeln können (gegebenenfalls auch umgekehrt), wobei diese Umwandlung vorzugsweise direkt und unmittelbar aufgrund des inneren Aufbaus der Piezoelementeinrichtung erfolgt. Insbesondere kann unter einer Piezoelementeinrichtung ein Piezokristall bzw. eine geeignete Anordnung von mehreren Piezokristallen verstanden werden, wobei gegebenenfalls auch weitere "Hilfskomponenten" dazu gehören können. Unter einer Wirkvermittlung mit einem externen Feld ist im Rahmen der vorliegenden Beschreibung insbesondere zu verstehen, dass die betreffende Komponente (bzw. die betreffenden Komponenten) beim nicht-Vorhandensein des betreffenden externen Felds im Wesentlichen nicht funktionstüchtig wären, zumindest jedoch einen deutlich schlechteren Wirkungsgrad aufweisen würden und/oder sonstige nachteilige Eigenschaften auftreten würden. Es kommt also in aller Regel zu einer Art Wechselwirkung zwischen der betreffenden Komponente (den betreffenden Komponenten) und dem externen Feld. Bei dem externen Feld kann es sich grundsätzlich um ein beliebiges Feld, wie beispielsweise ein elektrisches Feld, ein elektrostatisches Feld, ein elektromagnetisches Feld, ein magnetisches Feld, ein Kraftfeld und dergleichen handeln. Im Übrigen ist es nicht ausgeschlossen, dass das externe Feld auch zumindest teilweise und/oder zumindest zeitweise von der Energieübertragungsvorrichtung selbst erzeugt wird. Üblich ist es jedoch in der Regel, dass zumindest zeitweise ein in der Regel größerer Teil des externen Felds (bzw. der Großteil des externen Felds bzw. im Wesentlichen das gesamte externe Feld) durch externe Einrichtungen erzeugt wird, wobei es bevorzugt ist, wenn das externe Feld zu anderweitigen Zwecken ohnehin erzeugt werden muss bzw. vorhanden ist. Rein beispielhaft können in diesem Zusammenhang Kernspintomographen oder Ablenkmagneten bei Teilchenbeschleunigern genannt werden, wo funktionsbedingt starke (zum größeren Teil statische) Magnetfelder erzeugt werden müssen.

Dadurch, dass die zumindest eine Energieeintragseinrichtung derart ausgebildet und eingerichtet ist, dass sie zumindest teilweise und/oder zumindest zeitweise unter Wirkvermittlung eines magnetischen Felds arbeitet, ist die Energieübertragungsvorrichtung besonders geeignet, um beispielsweise im Zusammenhang mit Kernspintomographen, Teilchenbeschleunigern (hier insbesondere im Zusammenhang mit Ablenkmagneten, Fokussierungsmagneten und dergleichen) und dergleichen betrieben zu werden. In einem solchen Fall kann nicht nur vorteilhafter Weise auf eine magnetische Abschirmung verzichtet werden, sondern eine derartige Abschirmung kann im Gegenteil sogar unerwünscht sein. Hierdurch kann Bauraum gespart werden, Oberflächen von denen Gase desorbieren können können vermieden werden, Kosten können reduziert werden und dergleichen. Bei dem magnetischen Feld kann es sich in an sich beliebiger Weise um ein magnetisches Wechselfeld, ein (im Wesentlichen) statisches magnetisches Feld, sowie um ein (im Wesentlichen) statisches magnetisches Feld, welches mit einem gewissen wechselnden Anteil überlagert ist, handeln. Im Übrigen ist es selbstverständlich möglich, dass zusätzlich zum magnetischen Feld auch weitere Felder überlagert sein können.

Bei der Energieübertragungsvorrichtung ist die zumindest eine Energieeintragseinrichtung zumindest teilweise als elektrische Magnetfelderzeugungseinrichtung ausgebildet, wobei es bevorzugt ist, wenn die Energieeintragseinrichtung zumindest teilweise als elektrische Leiterschleifeneinrichtung und/oder zumindest teilweise als elektrische Spuleneinrichtung ausgebildet ist. Hierdurch kann es zu einer Wechselwirkung beispielsweise eines externen Magnetfelds und dem "lokal erzeugten" Magnetfeld kommen, so dass beispielsweise Kräfte auf die Energieeintragseinrichtung und/oder auf sonstige Komponenten der Energieübertragungsvorrichtung (insbesondere mit der Energieeintragseinrichtung in Kontakt stehende Bauteile) resultieren können. Ein derartiger Aufbau kann sich als einerseits besonders einfach, andererseits aber auch als vergleichsweise effektiv und gegebenenfalls auch als verschleißarm erweisen. Hierdurch können gegebenenfalls besonders kleine Bauformen der Energieübertragungsvorrichtung realisiert werden. Ein weiterer Vorteil kann sich durch die Richtungsabhängigkeit des bzw. der jeweiligen magnetischen Felder ergeben, so dass hier gewisse Richtungen "ausgeklammert" werden können bzw. umgekehrt bevorzugt werden können, was gegebenenfalls von Vorteil sein kann. Rein grundsätzlich kann es sich bei der Magnetfelderzeugungsvorrichtung um eine beliebige elektrische Magnetfelderzeugungseinrichtungen handeln, derart, dass durch Variation eines angelegten elektrischen Stroms ein unterschiedlich starkes "lokales" Magnetfeld erzeugt werden kann. Als geeignete Bauform hierfür haben sich insbesondere elektrische Leiterschleifen und/oder elektrische Spulen (bevorzugt ohne ferromagnetischen Kern) erwiesen.

Eine weiter bevorzugte Ausbildungsform der Energieübertragungsvorrichtung ergibt sich, wenn zumindest eine Energieeintragseinrichtung zumindest teilweise als feldverstärkungseinrichtungsfreie Energieeintragseinrichtung ausgebildet ist. Typischerweise wird bei elektrisch betriebenen Magnetfelderzeugungseinrichtungen (wie beispielsweise bei Spulen) zur Verstärkung des durch diese erzeugten "lokalen" Magnetfelds ein ferromagnetisches Materialstück (beispielsweise Ferritkerne, magnetische Joche aus ferromagnetischem Material und dergleichen) verwendet. Eine derartige Ausführungsform kann sich zwar als vorteilhaft erweisen, wenn vergleichsweise schwache externe Felder vorhanden sind. Wenn jedoch zumindest zeitweise sehr starke externe Felder (insbesondere Magnetfelder) vorhanden sind, so können sich derartige Feldverstärkungseinrichtungen bereits in einem (teilweisen) Sättigungszustand befinden, so dass die Effektivität der Energieeintragseinrichtung - und damit schlussendlich der Energieübertragungsvorrichtung - bis hin zur weitgehenden Unbrauchbarkeit verringert werden kann. Dies ist naturgemäß von Nachteil. Daher ist es sinnvoll, dass insbesondere im Zusammenhang mit starken externen Feldern (insbesondere Magnetfeldern) feldverstärkungseinrichtungsfreie Komponenten (insbesondere feldverstärkungseinrichtungsfreie Energieeintragseinrichtungen) genutzt werden, also beispielsweise Luft-Leiterschleifen bzw. Luft-Spuleneinrichtungen.

Weiterhin ist es von Vorteil, wenn bei der Energieübertragungsvorrichtung zumindest eine Energieeintragseinrichtung derart ausgebildet und eingerichtet ist, dass diese zumindest teilweise und/oder zumindest zeitweise mit elektrischer Energie beaufschlagt wird. Bei der elektrischen Energie kann es sich insbesondere um elektrische Wechselspannung handeln. Insbesondere ist es möglich durch unterschiedliche Formen der Wechselspannung (beispielsweise Sinuskurve, Sägezahnkurve, Rechteckkurve und dergleichen) und/oder durch unterschiedliche Pulsweitenverhältnisse und/oder durch unterschiedliche Frequenzen ein unterschiedliches Verhalten der Energieeintragseinrichtung zu bewirken. Hierdurch ist es möglich, dass beispielsweise eine mit der Energieeintragseinrichtung gekoppelte Energieerzeugungseinrichtung unterschiedliche elektrische Signale, insbesondere unterschiedlich im Hinblick auf Spannung, Stromstärke, Frequenz, Wellenform, Pulsweitenverhältnis und dergleichen erzeugen kann. Auf diese Weise kann die Energieübertragungsvorrichtung besonders flexibel genutzt werden. Weiterhin ist elektrische Energie im Zusammenhang mit elektrischen bzw. elektronischen Aufbauten in aller Regel ohnehin vorhanden, so dass diese vergleichsweise einfach "abgezweigt" werden kann. Weiterhin ist es möglich, dass bei einem Betrieb mit elektrischer Energie die zumindest eine Energieeintragseinrichtung besonders einfach aufgebaut sein kann.

Eine bevorzugte Ausführungsform der Energieübertragungsvorrichtung kann sich ergeben, wenn diese derart ausgebildet und eingerichtet ist, dass die zumindest eine Energieeintragseinrichtung zumindest teilweise und/oder zumindest zeitweise über zumindest eine Bewegung, insbesondere zumindest teilweise und/oder zumindest zeitweise über zumindest eine Translationsbewegung und/oder zumindest teilweise und/oder zumindest zeitweise über zumindest eine Rotationsbewegung auf die zumindest eine Energieerzeugungseinrichtung einwirkt, insbesondere mechanisch einwirkt. Eine derartige Wirkungsweise kann sich beispielsweise ergeben, wenn zumindest Teile einer elektrischen Leiterschleife bzw. einer Spule im Wesentlichen bündig mit einer Oberfläche eines Piezokristalls in Kontakt gebracht werden. Beim Anlegen eines entsprechenden elektrischen Stroms an die Leiterschleife bzw. die Spule kann sich dann im entsprechenden (Teil-)Bereich der Leiterschleife/Spule ein mechanischer Druck beziehungsweise eine mechanische Zugspannung im entsprechenden korrespondierenden Oberflächenbereich des Piezokristalls ergeben. Auf diese Weise kann eine einfache und besonders effektive Anordnung realisiert werden, wobei üblicherweise hohe Wirkungsgrade erzielt werden können.

Eine weitere bevorzugte Ausführungsform der Energieübertragungsvorrichtung kann sich ergeben, wenn diese derart ausgebildet und eingerichtet ist, dass die zumindest eine Energieeintragseinrichtung zumindest teilweise und/oder zumindest zeitweise über eine Verformungsbewegung auf die zumindest eine Energieerzeugungseinrichtung einwirkt, insbesondere mechanisch einwirkt. Hierbei kann es sich beispielsweise um eine Formveränderung der entsprechenden Energieeintragseinrichtung (insbesondere eine Leiterschleife bzw. eine elektrische Spule) handeln, beispielsweise derart, dass sich eine rechteckartige Formgebung sich zu einem Oval zu verformen versucht oder dergleichen. Auch ist es möglich, dass eine Größenveränderung der Energieeintragseinrichtung auftritt, wie beispielsweise bei einer kreisförmigen Leiterschleife bzw. Spule eine Radiuserhöhung bzw. Radiusverringerung. In diesem Zusammenhang sollte darauf hingewiesen werden, dass im Zusammenhang mit Piezoelementeinrichtungen üblicherweise Stellbewegungen im Mikrometerbereich ausreichend sind, so dass auch bei einer Größenveränderung einer Energieeintragseinrichtung üblicherweise eine hohe Standzeit der Energieeintragseinrichtung realisiert werden kann, auch wenn grundsätzlich Materialermüdungseffekte auftreten können bzw. in aller Regel auftreten. Selbstverständlich sind auch Mischformen aus den genannten "Extremen" "Bewegung" und "Verformung" möglich.

Weiterhin ist es von Vorteil, wenn bei der Energieübertragungsvorrichtung eine Mehrzahl von Energieeintragseinrichtungen und/oder eine Mehrzahl von Energieerzeugungseinrichtungen vorgesehen wird. Mit einem derartigen Aufbau können insbesondere unterschiedliche Übersetzungsverhältnisse bzw. Untersetzungsverhältnisse der eingegebenen und ausgegebenen Energien, Spannungen, Stromstärken, Frequenzen, Pulsweitenverhältnisse usw. realisiert werden. Beispielsweise kann durch einen entsprechenden mechanischen Aufbau eine Spannungserhöhung bzw. eine Spannungserniedrigung um einen bestimmten Faktor (bzw. in einem gewissen Faktorbereich) realisiert werden. Auch ist es möglich, dass die insgesamt übertragbare Energiemenge (bzw. Spannung und/oder Stromstärke) erhöht werden kann, was bei bestimmten Anwendungen von Vorteil sein kann. Insbesondere ist es auch möglich, dass die Verschaltung in Abhängigkeit von einem Steuersignal verändert werden kann.

Eine weitere bevorzugte Ausführungsform einer Energieübertragungsvorrichtung kann sich ergeben, wenn diese eine lineare Anordnung von zumindest einer Energieeintragseinrichtung und zumindest einer Energieerzeugungseinrichtung aufweist, insbesondere eine lineare Anordnung von einer Mehrzahl von Energieeintragseinrichtungen und/oder einer Mehrzahl von Energieerzeugungseinrichtungen. Mit einem derartigen Aufbau ist es einerseits möglich eine besonders kompakte Bauform zu realisieren. Darüber hinaus ist es möglich, dass Kombinationseffekte realisiert werden können, wie beispielsweise dass bei einer Leiterschleife zwei Seiten der Leiterschleife einen mechanischen Druck (und damit eine Energiegewinnung im dazu benachbarten Piezoelement) erzeugen können, auch wenn es sich um unterschiedliche Piezoelemente handelt. Hierdurch kann die Kompaktheit und Effektivität der resultierenden Energieübertragungsvorrichtung in der Regel nochmals gesteigert werden.

Im Folgenden wird die Erfindung anhand vorteilhafter Ausführungsbeispiele und unter Bezugnahme auf die beigefügte Zeichnung näher erläutert. Es zeigen:
- Fig. 1:: ein erstes Ausführungsbeispiel einer Energieübertragungseinheit in einem schematischen Querschnitt zu zwei unterschiedlichen Zeitpunkten;
- Fig. 2:: ein zweites Ausführungsbeispiel einer Energieübertragungseinheit in einem schematischen Querschnitt;
- Fig. 3:: ein drittes Ausführungsbeispiel einer Energieübertragungseinheit in einem schematischen Querschnitt.

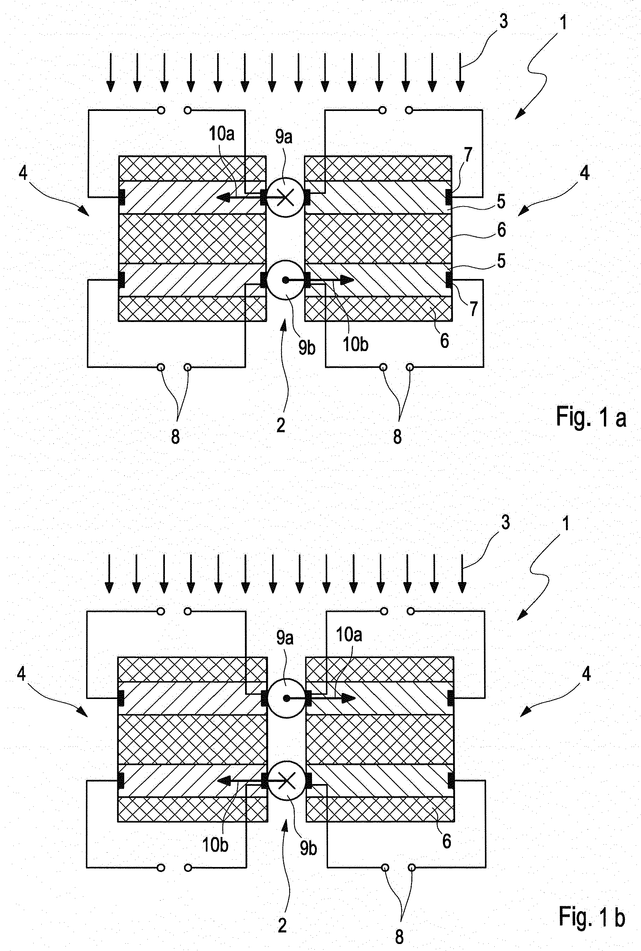

In Fig. 1 ist ein erstes mögliches Ausführungsbeispiel einer Energieübertragungseinheit 1 (Energieübertragungsvorrichtung) dargestellt. Die Energieübertragungseinheit 1 ist dabei in den Fig. 1 a und 1 b zu unterschiedlichen Zeitpunkten dargestellt; die Stromrichtung des in der elektrischen Spule 2 fließenden Stroms ist dabei umgekehrt, was im Folgenden noch eingehender beschrieben wird.

Die Energieübertragungseinheit 1 ist beispielsweise in einer Vorrichtung (nicht dargestellt) angeordnet, in welcher im Betrieb ein stärkeres Magnetfeld 3 auftritt. Bei einer derartigen Vorrichtung kann es sich beispielsweise um Ablenkmagneten eines Teilchenbeschleunigers oder um das (größtenteils statische) Magnetfeld eines Kernspintomographen handeln. Durch die Anordnung der Energieübertragungseinheit 1 in der entsprechenden Vorrichtung ist die Energieübertragungseinheit 1 dementsprechend dem Magnetfeld 3 ausgesetzt.

Die Energieübertragungseinheit 1 besteht aus zwei Blöcken 4, in denen im vorliegenden Ausführungsbeispiel jeweils zwei Piezoelemente 5 (hierbei kann es sich um kommerziell erhältliche Piezoelemente 5 handeln) angeordnet sind. Die Piezoelemente 5 sind unter Zwischenanordnung eines Füllmaterials 6 zueinander beanstandet angeordnet, wobei Piezoelemente 5 und Füllmaterial 6 im vorliegend dargestellten Ausführungsbeispiel fest miteinander verbunden sind, so dass sich jeweils ein einteiliger Block 4 ergibt. An den Außenseiten der Piezoelemente 5 ist jeweils eine Elektrode 7 angeordnet, so dass die in den Piezoelementen 5 erzeugten elektrischen Spannungen abgeleitet werden und an Kontaktklemmen 8 abgegriffen werden können. In der vorliegend dargestellten Fig. 1 sind die Kontaktklemmen 8 jeweils unabhängig voneinander ausgebildet. Selbstverständlich ist es möglich, dass die Kontaktklemmen 8 geeignet (teilweise) parallel und/oder (teilweise) seriell geschaltet werden können, so dass ein Ausgangsstrom mit größerer Stromstärke und/oder mit höherer Spannung erzeugt werden kann.

Wie weiterhin Fig. 1 entnommen werden kann, ist zwischen den beiden Blöcken 4 eine elektrische Spule 2 bündig auf "Kontakt" angeordnet. Die Anordnung aus elektrischer Spule 2 und Blöcken 4 kann selbstverständlich auch als einteilige Baugruppe realisiert und vermarktet werden. Die elektrische Spule 2 ist nicht notwendigerweise mit einem kreisrunden Querschnitt versehen. Vielmehr kann es sich auch um eine elektrische Spule (bzw. eine elektrische Leiterschleife) mit einem angenähert rechteckigen Querschnitt bzw. einem "abgeflacht ovalen" Querschnitt handeln (ähnlich einem Stadion, bei dem zwei Halbkreise jeweils mit einer geradlinigen Strecke miteinander verbunden sind). Bevorzugt sind geradlinige Leiterbereiche 9a, 9b der elektrischen Spule 2 so angeordnet, dass sie über eine möglichst große Strecke hinweg auf Höhe der jeweils dazu benachbarten Piezoelemente 5 angeordnet sind.

Wird nun die elektrische Spule 2 mit einem elektrischen Strom beaufschlagt (elektrische Stromzuführungsleiter zur Spule 2 sind aus Übersichtsgründen nicht dargestellt), so ergibt sich (je nach Phasenlage des angelegten elektrischen Stroms, insbesondere Wechselstroms) beispielsweise die in Fig. 1 a dargestellte Situation. Hier fließt der Strom im oberen Leiterbereich 9a der elektrischen Spule 2 in die Zeichenebene hinein (durch ein Kreuz angedeutet), während der elektrische Strom im unteren Leiterbereich 9b aus der Zeichenebene heraus strömt (durch einen Punkt dargestellt). Durch die Vermittlung des äußeren Magnetfelds 3 wird eine Kraft erzeugt, die so genannte Lorentzkraft 10. Diese weist beim oberen Leiterbereich 9a sowie beim unteren Leiterbereich 9b in unterschiedliche Richtungen, was durch entsprechend gerichtete Pfeile 10a, 10b angedeutet ist. Diese Kraftausübung erzeugt eine dazu korrespondierende elektrische Ladung im dazugehörigen Piezoelement 5, welche über die Elektroden 7 abgeführt wird und schlussendlich an den Kontaktklemmen 8 abgegriffen werden kann.

In Fig. 1b ist die Energieübertragungseinheit 1 in der "umgekehrten" Phasenlage dargestellt. Der in der elektrischen Spule 2 fließende Strom fließt in entgegengesetzter Richtung (beispielsweise Phase um 180° zur in Fig. 1 a dargestellten Situation versetzt). Dementsprechend wirken die auf die Piezoelemente 5 ausgeübten Lorentzkräfte 10a, 10b in jeweils entgegengesetzter Richtung. Die erzeugten elektrischen Spannungen unterscheiden sich dementsprechend im Vorzeichen.

Wenn durch Anlegen einer Wechselspannung an die elektrische Spule 2 die Situation von Fig. 1 a und Fig. 1b zyklisch wiederholt wird, so kann an den Kontaktklemmen 8 jeweils eine entsprechende Wechselspannung abgegriffen werden (wobei die Wechselspannungen gegebenenfalls auch geeignet miteinander verschaltet werden können).

Der Strom durch die elektrische Spule 2 erzeugt im Übrigen die Kraft F, die sich aus *F* = *B · i · l · N* berechnet. Dabei ist F die Kraft 10, die die Leiterbereiche 9a, 9b auf die Piezoelemente 5 ausüben, B ist die Magnetfeldstärke des Magnetfelds 3, i ist der Strom durch die elektrische Spule 2 und I ist die Leiterlänge der Leiterbereiche 9a, 9b über den Piezoelementen 5. N ist die Windungszahl der elektrischen Spule 2.

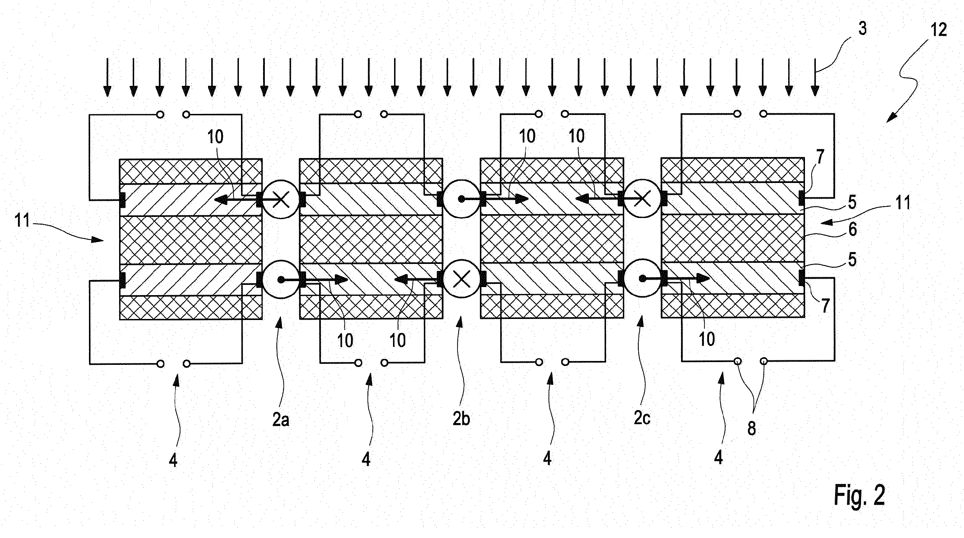

In Fig. 2 ist in einer schematischen Querschnittsdarstellung dargestellt, wie eine größere Anzahl an Blöcken 4 (ähnlich wie in Fig. 1 ausgebildet) mit jeweils zwei Piezoelementen 5 zur Ausbildung einer linear angeordneten Energieübertragungseinheit 12 mit jeweils zwischenliegenden elektrischen Spulen 2 linear angeordnet werden können. Im vorliegend dargestellten Ausführungsbeispiel werden vier Blöcke 4 verwendet, wobei die Anzahl an Blöcken 4 auch unterschiedlich sein kann (wie beispielsweise 3, 5, 6, 7, 8, 9 oder 10 Blöcke 4). Weiterhin ist beim in Fig. 2 dargestellten Ausführungsbeispiel jeweils zwischen zwei Blöcken 4 eine elektrische Spule 2 angeordnet, wohingegen an den Außenseiten 11 der linear angeordneten Energieübertragungseinheit 12 keine elektrischen Spulen 2 vorgesehen sind. Dies kann selbstverständlich auch anders gestaltet werden, also mit einer elektrischen Spule 2 an einer oder an beiden Außenseiten 11.

Es wird darauf hingewiesen, dass die bei der in Fig. 2 dargestellten linear angeordneten Energieübertragungseinheit 12 verwendeten elektrischen Spulen 2 jeweils so geschaltet sind, dass diese abwechselnd im entgegengesetzten Sinn von elektrischem Strom durchflossen werden. Die elektrischen Spulen 2a, 2c sind damit gleichsinnig geschaltet, wohingegen die mittlere elektrische Spule 2b entgegengesetzt zu den elektrischen Spulen 2a, 2c geschaltet ist. Dadurch ergeben sich jeweils zusammenwirkende Lorenzkräfte 10 in den Piezoelementen 5. Die lineare Anordnung 12 wird dadurch deutlich effektiver.

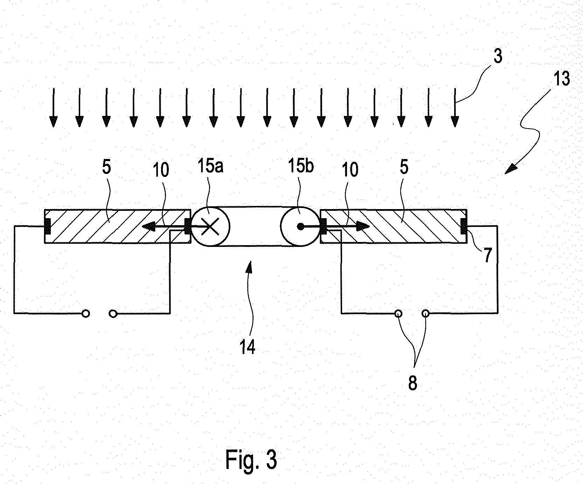

In Fig. 3 ist ein drittes mögliches Ausführungsbeispiel einer Energieübertragungseinheit 13 dargestellt. Hier ist die elektrische Spule 14 "liegend" zwischen zwei Piezoelementen 5 angeordnet. Die Kraftausübung der die Piezoelemente 5 kontaktierenden Leiterbereiche 15a, 15b der elektrischen Spule 14 beruht daher nicht auf einem Drehmoment der elektrischen Spule (so wie bei den in Fig. 1 und Fig. 2 dargestellten Ausführungsbeispielen der Energieübertragungseinheiten 1, 12), sondern beruht vielmehr auf einem Schrumpfen bzw. Ausdehnen ("Pumpen") der elektrischen Spule 14. Da, wie bereits erwähnt, typischerweise lediglich Bewegungen im Bereich von Mikrometern erforderlich sind, kann ein derartiges "Pumpen" der elektrischen Spule 14 jedoch realisiert werden, ohne dass es zu einer übermäßigen Materialermüdung der Leiter der elektrischen Spule 14 kommt.

Wie bereits im Zusammenhang mit den in Fig. 1 und 2 dargestellten Ausführungsbeispielen von Energieübertragungseinheiten 1, 12 erwähnt, muss auch vorliegend die elektrische Spule 14 nicht notwendigerweise einen kreisrunden Querschnitt haben. Vielmehr können auch hier im Wesentlichen rechteckartige und/oder "abgeflacht ovale" Querschnittsformen zur Anwendung kommen.

Für sämtliche in den Fig. 1 bis 3 dargestellten Ausführungsbeispiele von Energieübertragungseinheiten 1, 12, 13 (und gegebenenfalls weiterer Bauausführungen), sind typische Werte, bei denen sich in ersten Versuchen sinnvolle Ergebnisse realisieren ließen, folgende Werte:
Für das Magnetfeld 3 können typischerweise Magnetfelder im Bereich von H = 0,5 Tesla verwendet werden. Typische Windungszahlen für die elektrischen Spulen 2, 14 sind N = 100-200 Windungen. Als typische Stromstärke für die elektrischen Spulen 2, 14 können Ströme im Bereich von i = 10 mA verwendet werden. Die Frequenz des elektrischen Stroms, mit dem die elektrischen Spulen 2, 14 beaufschlagt werden, liegt typischerweise im Bereich zwischen F = 10 kHz und 100 kHz.

### Bezugszeichenliste:

- 1.: Energieübertragungseinheit
- 2.: Elektrische Spule
- 3.: Magnetfeld
- 4.: Block
- 5.: Piezoelement
- 6.: Füllmaterial
- 7.: Elektrode
- 8.: Kontaktklemme
- 9.: Leiterbereich
- 10.: Lorentzkraft
- 11.: Außenseite
- 12.: Energieübertragungseinheit
- 13.: Energieübertragungseinheit
- 14.: Elektrische Spule
- 15.: Leiterbereich

## Patentansprüche

1. Energieübertragungsvorrichtung (1, 12, 13), aufweisend zumindest eine Energieeintragseinrichtung (2) und zumindest eine als Piezoelementeinrichtung ausgebildete Energieerzeugungseinrichtung (4, 5), **dadurch gekennzeichnet, dass** die zumindest eine Energieeintragseinrichtung (2) zumindest teilweise als elektrische Magnetfelderzeugungseinrichtung (2) ausgebildet ist und derart ausgebildet und eingerichtet ist, dass sie zumindest teilweise und/oder zumindest zeitweise unter Wirkvermittlung eines externen magnetischen Felds (3) arbeitet, derart, dass sie eine Lorenzkraft auf die zumindest eine Energieerzeugungseinrichtung (4, 5) ausübt.

2. Energieübertragungsvorrichtung (1, 12, 13) nach Anspruch 1, **dadurch gekennzeichnet, dass** die zumindest eine Energieeintragseinrichtung (2) zumindest teilweise als elektrische Leiterschleifeneinrichtung und/oder zumindest teilweise als elektrische Spuleneinrichtung (2) ausgebildet ist.

3. Energieübertragungsvorrichtung (1, 12, 13) nach einem der vorangehenden Ansprüche, insbesondere nach Anspruch 2, **dadurch gekennzeichnet, dass** zumindest eine Energieeintragseinrichtung (2) zumindest teilweise als feldverstärkungseinrichtungsfreie Energieeintragseinrichtung (2) ausgebildet ist.

4. Energieübertragungsvorrichtung (1, 12, 13) nach einem der vorangehenden Ansprüche, **dadurch gekennzeichnet, dass** zumindest eine Energieeintragseinrichtung (2) derart ausgebildet und eingerichtet ist, dass diese zumindest teilweise und/oder zumindest zeitweise mit elektrischer Energie beaufschlagt wird.

5. Energieübertragungsvorrichtung (1, 12, 13) nach einem der vorangehenden Ansprüche, **dadurch gekennzeichnet, dass** diese derart ausgebildet und eingerichtet ist, dass die zumindest eine Energieeintragseinrichtung (2) zumindest teilweise und/oder zumindest zeitweise über zumindest eine Bewegung, insbesondere zumindest teilweise und/oder zumindest zeitweise über zumindest eine Translationsbewegung und/oder zumindest teilweise und/oder zumindest zeitweise über zumindest eine Rotationsbewegung (Fig. 1, Fig. 2) auf die zumindest eine Energieerzeugungseinrichtung (4, 5) einwirkt, insbesondere mechanisch (10) einwirkt.

6. Energieübertragungsvorrichtung (1, 12, 13) nach einem der vorangehenden Ansprüche, **dadurch gekennzeichnet, dass** diese derart ausgebildet und eingerichtet ist, dass die zumindest eine Energieeintragseinrichtung (2) zumindest teilweise und/oder zumindest zeitweise über eine Verformungbewegung (Fig. 3) auf die zumindest eine Energieerzeugungseinrichtung (4, 5) einwirkt, insbesondere mechanisch (10) einwirkt.

7. Energieübertragungsvorrichtung (1, 12, 13) nach einem der vorangehenden Ansprüche, **gekennzeichnet durch** eine Mehrzahl von Energieeintragseinrichtungen (2) und/oder **durch** eine Mehrzahl von Energieerzeugungseinrichtungen (4, 5).

8. Energieübertragungsvorrichtung (1, 12, 13) nach einem der vorangehenden Ansprüche, insbesondere nach Anspruch 7, **gekennzeichnet durch** eine lineare Anordnung (1, 12, 13) von zumindest einer Energieeintragseinrichtung (2) und zumindest einer Energieerzeugungseinrichtung (4, 5), insbesondere von einer Mehrzahl von Energieeintragseinrichtungen (2) und/oder einer Mehrzahl von Energieerzeugungseinrichtungen (4, 5).

## Claims

1. Energy transmission apparatus (1, 12, 13), comprising at least one energy input device (2) and at least one energy generation device (4, 5) implemented as a piezoelectric element device, **characterised in that** the at least one energy input device (2) is implemented at least partially as an electrical magnetic field generation device (2), and is implemented and arranged in such a way that it works at least partially and/or at least some of the time under the active mediation of an external magnetic field (3) in order to exercise a Lorentz force on the at least one energy generation device (4, 5).

2. Energy transmission apparatus (1, 12, 13) according to Claim 1, **characterised in that** the at least one energy input device (2) is implemented at least partly as an electric conductor loop device and/or at least partially as an electric coil device (2).

3. Energy transmission apparatus (1, 12, 13) according to one of the previous claims, in particular according to Claim 2, **characterised in that** at least one energy input device (2) is implemented at least partially as an energy input device (2) that has no field enhancement device.

4. Energy transmission apparatus (1, 12, 13) according to one of the previous claims, **characterised in that** at least one energy input device (2) is implemented and arranged in such a way that it is at least partially and/or at least some of the time impinged upon by electrical energy.

5. Energy transmission apparatus (1, 12, 13) according to one of the previous claims, **characterised in that** it is implemented and arranged in such a way that the at least one energy input device (2) acts, in particular acts mechanically (10), on the at least one energy generation device (4, 5), at least partially and/or at least some of the time through at least one movement, in particular through at least partially and/or at least some of the time through at least one translation movement and/or at least partially and/or at least some of the time through at least one rotation movement (Fig. 1, Fig. 2).

6. Energy transmission apparatus (1, 12, 13) according to one of the previous claims, **characterised in that** it is implemented and arranged in such a way that the at least one energy input device (2) acts, in particular acts mechanically (10), on the at least one energy generation device (4, 5) at least partially and/or a least some of the time through a deforming movement (Fig. 3).

7. Energy transmission apparatus (1, 12, 13) according to one of the previous claims, **characterised by** a plurality of energy input devices (2) and/or by a plurality of energy generation devices (4, 5).

8. Energy transmission device (1, 12, 13) according to one of the previous claims, in particular according to Claim 7, **characterised by** a linear arrangement (1, 12, 13) of at least one energy input device (2) and at least one energy generation device (4, 5), in particular by a plurality of energy input devices (2) and/or a plurality of energy generation devices (4, 5).

## Revendications

1. Dispositif de transfert d'énergie (1, 12, 13), comprenant au moins un appareil d'alimentation en énergie (2) et au moins un appareil de production d'énergie (4, 5) conçu sous forme d'appareil d'éléments piézoélectriques, **caractérisé en ce que** l'au moins un appareil d'alimentation en énergie (2) est conçu au moins partiellement en tant qu'appareil électrique de production de champ magnétique (2) et est réalisé et ajusté de manière à fonctionner au moins partiellement et/ou au moins par intermittence par l'entremise d'un champ magnétique (3) externe de sorte à exercer une force de Lorentz sur l'au moins un appareil de production d'énergie (4, 5).

2. Dispositif de transfert d'énergie (1, 12, 13) selon la revendication 1, **caractérisé en ce que** l'au moins un appareil d'alimentation en énergie (2) est conçu au moins partiellement en tant que dispositif électrique à boucle conductrice et/ou au moins partiellement en tant que dispositif électrique à bobine (2).

3. Dispositif de transfert d'énergie (1, 12, 13) selon l'une des revendications précédentes, en particulier selon la revendication 2, **caractérisé en ce qu'**au moins un appareil d'alimentation en énergie (2) est conçu au moins partiellement en tant qu'appareil d'alimentation en énergie (2) sans dispositif de renforcement de champ.

4. Dispositif de transfert d'énergie (1, 12, 13) selon l'une des revendications précédentes **caractérisé en ce qu'**au moins un appareil d'alimentation en énergie (2) est réalisé et ajusté de manière telle qu'il est alimenté en énergie électrique au moins partiellement et/ou au moins par intermittence.

5. Dispositif de transfert d'énergie (1, 12, 13) selon l'une des revendications précédentes, **caractérisé en ce que** ledit dispositif est réalisé et ajusté de manière telle que l'au moins un appareil d'alimentation en énergie (2) agit, en particulier de manière mécanique (10), sur l'au moins un appareil de production d'énergie (4, 5) au moins partiellement et/ou au moins par intermittence par au moins un mouvement, en particulier au moins partiellement et/ou au moins par intermittence par au moins un mouvement de translation et/ou au moins partiellement et/ou au moins par intermittence par au moins un mouvement de rotation (Fig. 1, Fig. 2).

6. Dispositif de transfert d'énergie (1, 12, 13) selon l'une des revendications précédentes, **caractérisé en ce que** ledit dispositif est réalisé et ajusté de manière telle que l'au moins un appareil d'alimentation en énergie (2) agit, en particulier de manière mécanique (10), sur l'au moins un appareil de production d'énergie (4, 5) au moins partiellement et/ou au moins par intermittence par un mouvement de déformation (Fig. 3).

7. Dispositif de transfert d'énergie (1, 12, 13) selon l'une des revendications précédentes, **caractérisé par** une pluralité d'appareils d'alimentation en énergie (2) et/ou par une pluralité d'appareils de production d'énergie (4, 5).

8. Dispositif de transfert d'énergie (1, 12, 13) selon l'une des revendications précédentes, en particulier selon la revendication 7, **caractérisé par** un arrangement linéaire (1, 12, 13) d'au moins un appareil d'alimentation en énergie (2) et au moins un appareil de production d'énergie (4, 5), en particulier d'une pluralité d'appareils d'alimentation en énergie (2) et/ou d'une pluralité d'appareils de production d'énergie (4, 5).
